# EUROPÄISCHE PATENTSCHRIFT

(11) **EP 1 073 531 B1**
(45) Veröffentlichungstag und Bekanntmachung des Hinweises auf die Patenterteilung: **04.09.2002**
(21) Anmeldenummer: 99919267.7
(22) Anmeldetag: 23.04.1999
(51) Int. Cl.: B08B 9/02, C23C 16/44

(54) **VORRICHTUNG UND VERFAHREN ZUR DRUCKWECHSELSPÜLUNG**
DEVICE AND METHOD FOR ALTERNATING PRESSURE FLUSHING
DISPOSITIF ET PROCEDE DE LAVAGE ALTERNE SOUS PRESSION

(30) Priorität: 23.04.1998 DE 19818306
(43) Veröffentlichungstag der Anmeldung: 07.02.2001
(73) Patentinhaber: Intega Hans J. Jehl GMBH, 82041 Oberhaching (DE)
(72) Erfinder: SCHULZ, Christoph, D-76316 Malsch (DE)
(74) Vertreter: Beier, Ralph, Dipl.-Ing.
(86) Internationale Anmeldenummer: EP9902785
(87) Internationale Veröffentlichungsnummer: WO99055472

(56) Entgegenhaltungen:
- EP-A- 0 382 985
- EP-A- 0 626 214
- US-A- 3 582 142
- US-A- 4 913 192
- PATENT ABSTRACTS OF JAPAN vol. 17, no. 591 (C-1125), 28. Oktober 1993 (1993-10-28) -& JP 05 177126 A (FURUKAWA ELECTRIC CO LTD), 20. Juli 1993 (1993-07-20)

## Beschreibung

Die Erfindung betrifft eine Vorrichtung zur Druckwechselspülung eines Raumes, wie z. B. einer Prozeßgasanlage mit einer mit dem Raum verbundenen Spülgaszuleitung, in welcher unter Druck stehendes Spülgas zugeführt wird und einer ebenso mit dem Raum verbundenen Spülgasableitung sowie einem Vakuumgenerator.

Die Erfindung betrifft ebenso ein Verfahren zur Druckwechselspülung.

Aus der EP 0 382 985A1 ist eine derartige Vorrichtung bekannt. Die Vorrichtung ist in Fig. 1 der Zeichnungen dargestellt, auf welche sich auch die nachfolgend angegebenen Bezugszeichen beziehen.

Der zu spülende Raum ist in diesem Fall die Prozeßgasleitung 4, welche über das Flaschenventil 2 an einer Prozeßgasflasche 1 angeschlossen ist. Die Prozeßgasleitung 4 kann gegenüber der Prozeßgasanlage durch ein weiteres Ventil 3 abgesperrt werden. Der zu spülende Raum wird somit durch den Bereich zwischen den Ventilen 2 und 3 beschränkt. In einer Spülgaszuleitung 7 wird Spülgas unter Druck in den zu spülenden Raum zugeführt und in der Spülgasableitung 9 wieder abgeführt. In der Spülgasableitung 9 ist als Vakuumgenerator eine Vakuumpumpe 10 vorgesehen, welche das Gas aus der Spülgasleitung 9 somit auch aus dem zu spülenden Raum zieht. Zwischen Vakuumgenerator 10 und Prozeßleitung 4 ist in der Spülgasleitung 9 ein Ventil 8 vorgesehen. Die Spülgaszuleitung weist ebenso ein Ventil 6 auf.

Beim Spülvorgang sind die Ventile 2, 3 und 6 geschlossen, das Ventil 8 geöffnet. Die Vakuumpumpe reduziert den Druck in der Spülgasleitung 9 sowie in dem zu spülenden Raum.

Im nächsten Schritt wird das Ventil 8 geschlossen und das Ventil 6 geöffnet, so daß Spülgas unter Druck in den zu spülenden Raum gelangt. Hat das Spülgas in dem zu spülenden Raum einen bestimmten Druck erreicht, wird das Ventil 6 geschlossen und das Ventil 8 wieder geöffnet, um die Spülleitung und den zu spülenden Raum wieder durch die Vakuumpumpe zu evakuieren.

Diese Vorrichtung weist den Nachteil auf, daß durch den Unterdruck in der Spülleitung 9 sowie in dem zu spülenden Raum das Öl aus der Vakuumpumpe in diesen Bereich gezogen wird und ihn verunreinigt. Dies ist insbesondere bei der Verwendung der Spülmethode in Prozeßgasanlagen für Reinstgas äußerst ungünstig. Der Effekt, daß das Öl in diesen unerwünschten Bereich gelangt, tritt verstärkt dann auf, wenn das Vakuum so stark ist, daß der Dampfdruck des Öls unterschritten wird. In der EP 0 382 985A1 wurde zur Lösung dieses Problems eine Druckdose 11 vorgeschlagen, welche das Ventil 8 schließt, bevor der Dampfdruck für das Öl in der Vakuumpumpe unterschritten wird.

Die Vorrichtung hat den Nachteil, daß die Ventile 6 und 8 in Abhängigkeit von der Druckdose 11 gesteuert werden müssen, was somit eine aufwendigere Steuerung bedingt. Ein weiterer Nachteil ist, daß beim Versagen der Druckdose die Spülgasleitung und die Prozeßleitung verunreinigt werden. Die Druckdose kann auch nur eine sehr starke Ausbreitung des Öls in Richtung Spülgasableitung verhindern, indem der Druck über dem Dampfdruck des Öls gehalten wird. Eine minimale Ausbreitung des Öls im flüssigen Zustand ist jedoch stets gegeben. .

Aus der europäischen Patentanmeldung EP 0 626 214 Al sowie aus der japanischen Patentanmeldung JP-A-05177126 ist eine Vorrichtung zur Druckwechselspülung eines Raums einer Prozeßgasanlage bekannt mit einer mit dem Raum verbundenen Spülgaszuleitung, in welcher unter Druck stehendes Spülgas zugeführt wird und einer ebenso mit dem Raum verbundenen Spülgasableitung sowie einer Drosseleinrichtung, die als Vakuumgenerator verwendet wird, wobei der in Strömungsrichtung unmittelbar nach der Drosselung entstehende Unterdruck zur Evakuierung des zu spülenden Raums genutzt wird. Die Spülgaszuleitung und die Spülgasableitung sind hierbei miteinander über die Drosseleinrichtung verbunden und in Strömungsrichtung der Spülgaszuleitung ist unmittelbar nach der Drosseleinrichtung die Spülgaszu- bzw. Spülgasableitung mit dem zu spülenden Raum verbunden. Weiterhin ist in der Spülgasableitung in Strömungsrichtung des Spülgases nach der Drosseleinrichtung ein Ventil angeordnet. Diese bekannte Vorrichtung zur Druckwechselspülung ermöglicht jedoch nur eine unbefriedigende Spülung.

Der Erfindung liegt daher die Aufgabe zugrunde, eine Vorrichtung zur Druckwechselspülung anzugeben, welche einfach aufgebaut ist, nicht die Gefahr einer Kontamination durch Öl birgt und darüber hinaus eine wirksame Spülung ermöglicht.

Diese Aufgabe wird erfindungsgemäß dadurch gelöst, daß als Vakuumgenerator eine Drosseleinrichtung verwendet wird, bei welcher der in Strömungsrichtung unmittelbar nach der Drosselung entstehende Unterdruck genutzt wird. Weiterhin ist ein Leitungsabschnitt der Spülgaszuleitung und ein Leitungsabschnitt der Spülgasableitung miteinander über die Drosseleinrichtung verbunden, wobei in Strömungsrichtung der Spülgaszuleitung unmittelbar nach der Drosselung eine gemeinsame Spülgasleitung, welche sowohl als Spülgaszu- und als Spülgasableitung wirkt, die Spülgaszu- bzw. die Spülgasableitung mit dem zu spülenden Raum verbindet. In der Spülgasableitung ist in Strömungsrichtung des Spülgases nach der Drosseleinrichtung ein Ventil angeordnet, welches bei der Druckwechselspülung alternierend geöffnet und geschlossen wird. Ist das Ventil geschlossen, so strömt das unter Druck stehende Spülgas durch die gemeinsame Spülleitung in den zu spülenden Raum. Wird das Ventil göffnet, so strömt das Spülgas direkt von der Spülgaszuleitung durch die Drosseleinrichtung in die Spülgasableitung, wobei der unmittelbar nach der Drosselung entstehende Unterdruck das Gas aus der gemeinsamen Spülleitung sowie aus dem zu spülenden Raum zieht.

Durch die Verwendung eines Vakuumgenerators in Form einer Drosseleinrichtung ist kein Öl zur Schmierung notwendig, so daß die Gefahr der Kontamination durch Öl ausgeräumt ist. Die Drosseleinrichtung wird vorzugsweise mit Spülgas betrieben, so daß auch nicht die Gefahr einer Kontamination durch das Gas, mit welcher die Drosseleinrichtung betrieben wird, besteht.

Als Drosseleinrichtung wird vorzugsweise eine Venturidüse oder eine Meßblende verwendet.

Das Ventil wird vorzugsweise über eine Steuereinrichtung betätigt, wobei diese äußerst einfach aufgebaut ist, da sie lediglich alternierend das Ventil öffnet und schließt.

In der Spülgaszuleitung ist günstigerweise in Strömungsrichtung vor der Drosseleinrichtung ein zweites Ventil angeordnet, um ein Auswechseln des Spülgasvorrats zu ermöglichen.

Die gemeinsame Spülgasleitung kann sich in mehrere Leitungen aufzweigen, wobei diese Zweigleitungen entweder an verschiedenen Stellen eines zu spülenden Raumes münden, bzw. zu verschiedenen zu spülenden Räumen münden können.

In der gemeinsamen Spülgasleitung bzw. in den Zweigleitungen sind vorzugsweise Ventile vorgesehen, die nach beendigter Spülung den zu spülenden Raum von der Spülvorrichtung trennen.

Sowohl die Spülgasvorrichtung als auch das beschriebene Verfahren werden vorzugsweise in Gastableaus eingesetzt.

Nachfolgend wird die Erfindung anhand in den Zeichnungen dargestellter Ausführungsbeispiele näher erläutert.

In den Zeichnungen zeigen
- Fig. 1: eine Druckwechselspülvorrichutng gemäß dem Stand der Technik;
- Fig. 2: eine Schemazeichnung der erfindungsgemäßen Druckwechselspülvorrichtung;
- Fig. 3: eine vergrößerte Ansicht der Drosselvorrichtung in Ausbildung als Venturidüse;
- Fig. 4: ebenfalls eine vergrößerte Ansicht der Drosselvorrichtung in einer Ausbildung mit Meßblende und
- Fig. 5: ein Gastableau mit der erfindungsgemäßen Spülvorrichtung.

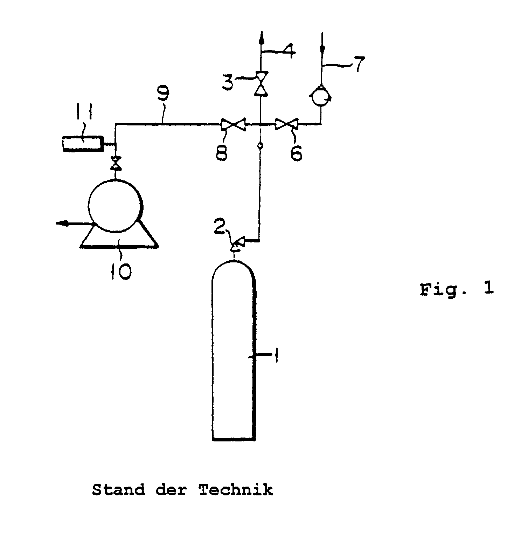

Fig. 1 zeigt in schematischer Darstellung eine Druckwechselspülvorrichtung, wie sie in der EP 0 382 985A1 aufgezeigt ist. Die Vorrichtung wurde bereits in der Beschreibungseinleitung beschrieben.

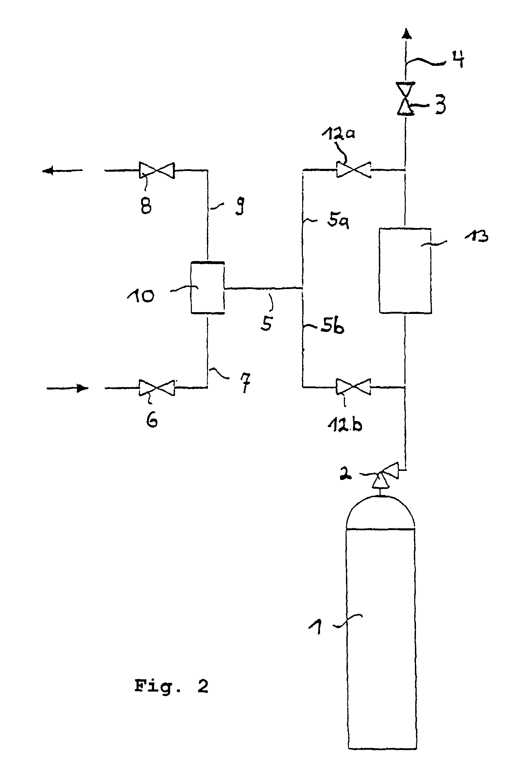

Fig. 2 zeigt eine Schemaskizze der erfindungsgemäßen Druckwechselspülvorrichtung, wobei für identische Bauteile die gleichen Bezugszeichen wie in der Vorrichtung nach dem Stand der Technik gemäß Fig. 1 verwendet wurden.

Der zu spülende Raum besteht bei der Vorrichtung gemäß Fig. 2 aus der Prozeßgasleitung 4, welche auf der einen Seite über ein Flaschenventil 2 an eine Prozeßgasflasche 1 angeschlossen ist und in die andere Richtung durch ein Ventil 3 von einer Prozeßgasanlage abgetrennt werden kann. In der Prozeßgasleitung 4 kann sich zwischen den Ventilen 2 und 3 ein Flußregler 13 in Form eines weiteren Ventils oder eines Druckminderers befinden. Aufgabe der Druckwechselspülung ist es, den Bereich zwischen den Ventilen 2 und 3 in der Prozeßgasleitung 4 vom Prozeßgas zu reinigen.

Unter Druck stehendes Spülgas wird über die Spülgaszuleitung 7,5 in den zu spülenden Bereich eingeleitet und über die Leitungen 5 und 9 wieder abgeleitet. Die Leitung 5 ist somit in einem Spülgaszuleitung sowie auch Spülgasableitung. Im dargestellten Ausführungsbeispiel zweigt sich die Leitung 5 in die Leitungen 5a und 5b auf, welche jeweils vor und nach dem Flußregler 13 in die Prozeßleitung 4 münden. Um die Spülvorrichtung von der Prozeßgasleitung 4 abzukoppeln, sind in den Spülleitungen 5a und 5b die Ventile 12a und 12b vorgesehen.

Die Spülgaszuleitung 7 geht in der Drosseleinrichtung 10 kontinuierlich in die Spülgasableitung 9 über, wobei die Spülgasleitung 5 T-förmig nach der Drosselung abzweigt. In der Spülzuleitung 7 ist vor der Drosseleinrichtung 10 ein Ventil 6 und in der Spülableitung 9 nach der Drosseleinrichtung 10 ein Ventil 8 angeordnet.

Nachfolgend wird das Prinzip der Druckwechselspülung beschrieben.

Die Ventile 2 und 3 werden geschlossen und die Ventile 6 und 8 sowie 12a und 12b werden geöffnet. Das Spülgas wird über Druck in die Leitung 7 eingeleitet. Es strömt durch die Drosselvorrichtung 10 und fließt über die Leitung 9 wieder ab. Durch den kurz nach der Drosselung entstehenden Unterdruck wird das Prozeßgas über die Leitungen 5a und 5 sowie 5b und 5 abgezogen, so daß in diesen Leitungen ein gewisser Unterdruck herrscht. Im nächsten Schritt wird das Ventil 8 geschlossen, so daß das Spülgas über die Leitungen 7, 5, 5a und 5b in den zu spülenden Bereich gelangt und diesen unter Druck setzt.

Anschließend wird das Ventil 8 wieder geöffnet, wodurch daß das in den Leitungen 5, 5a, 5b und in dem zu spülenden Raum enthaltene Gas abgezogen wird. Zur Druckwechselspülung muß somit lediglich das Ventil 8 geöffnet und geschlossen werden.

Ist die Spülung beendet, werden die Ventile 12a und 12b geschlossen.

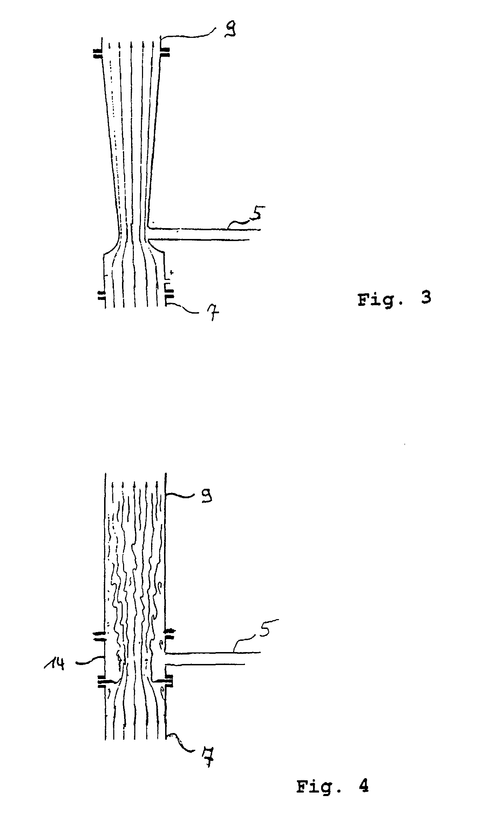

Fig. 3 zeigt die Drosseleinrichtung 10 in vergrößertem Maßstab, wobei als Drosseleinrichtung eine Venturidüse verwendet wurde. Die Venturidüse ist zwischen den Leitungen 7 und 9 angeordnet und unmittelbar nach der Drosselung zweigt die Spülgasleitung 5 ab.

Fig. 4 zeigt ebenfalls die Drosseleinrichtung 10 in vergrößertem Maßstab, wobei hier als Drossel eine Meßblende verwendet wird. Die Spülgasleitung 5 zweigt unmittelbar nach der Meßblende von einem zwischen den Leitungen 7 und 9 eingesetzten Leitungsstück 14 ab.

Sowohl bei der Venturidüse gemäß Fig. 3 als auch bei der Meßblende gemäß Fig. 4 ist die Spülgasleitung 5 jeweils an demjenigen Ort nach der Drosselung angeordnet, welcher aufgrund der Strömung den niedrigsten Druck aufweist.

Durch den Einsatz einer Drosseleinrichtung in der Anlage gemäß Figur 2 wird der Verbrauch von Spülgas im Vergleich zu der gleichen Anlage ohne Drosseleinrichtung erheblich herabgesetzt.

Die nachstehende Tabelle zeigt die Verdünnungen bei einer Anlage gemäß Figur 2 über 20 Spülzyklen, bei welcher einmal mit Venturi-Düse (siehe linke Spalte) und einmal ohne Venturi-Düse (siehe mittlere Spalte) gearbeitet wurde. In der rechten Spalte ist der Gasverbrauch in ccm pro Meter 6x1 Rohr aufgeführt.

| Druckwechselspülung | | | |
|---|---|---|---|
| | mit | ohne | Gasverbrauch ccm |
| | Venturidüse | Venturidüse | pro m 6x1 Rohr |
| 1 | 3,33E-02 | 1,67E-01 | 300 |
| 2 | 1,11E-03 | 2,78E-02 | 600 |
| 3 | 3,70E-05 | 4,63E-03 | 900 |
| 4 | 1,23E-06 | 7,72E-04 | 1200 |
| 5 | 4,12E-08 | 1,29E-04 | 1500 |
| 6 | 1,37E-09 | 2,14E-05 | 1800 |
| 7 | 4,57E-11 | 3,57E-06 | 2100 |
| 8 | 1,52E-12 | 5,95E-07 | 2400 |
| 9 | 5,08E-14 | 9,92E-08 | 2700 |
| 10 | 1,69E-15 | 1,65E-08 | 3000 |
| 11 | 5,65E-17 | 2,76E-09 | 3300 |
| 12 | 1,88E-18 | 4,59E-10 | 3600 |
| 13 | 6,27E-20 | 7.65E-11 | 3900 |
| 14 | 2,09E-21 | 1,28E-11 | 4200 |
| 15 | 6,97E-23 | 2,13E-12 | 4500 |
| 16 | 2,32E-24 | 3,54E-13 | 4800 |
| 17 | 7,74E-26 | 5,91E-14 | 5100 |
| 18 | 2,58E-27 | 9,85E-15 | 5400 |
| 19 | 8,60E-29 | 1,64E-15 | 5700 |
| 20 | 2,87E-30 | 2,74E-16 | 6000 |

Durch den Einsatz der Venturi-Düse wird bereits nach 11 Spülzyklen eine höhere Verdünnung erreicht, als bei einer Druckwechselspülung ohne Venturi-Düse nach 20 Spülzyklen erreicht wird.

Wie aus den absoluten Werten für den Gasverbrauch pro Meter zu spülendes 6x1 Rohr zu sehen ist, wird durch den Einsatz einer Venturi-Düse bei bereits einer sehr geringen Spülgasmenge eine hohe Verdünnung und somit eine sehr gute Effizienz erreicht.

Das Verhältnis von Spülgasmenge zu Effizienz ist auch erheblich günstiger als in anderen aus dem Stand der Technik bekannten Verfahren.

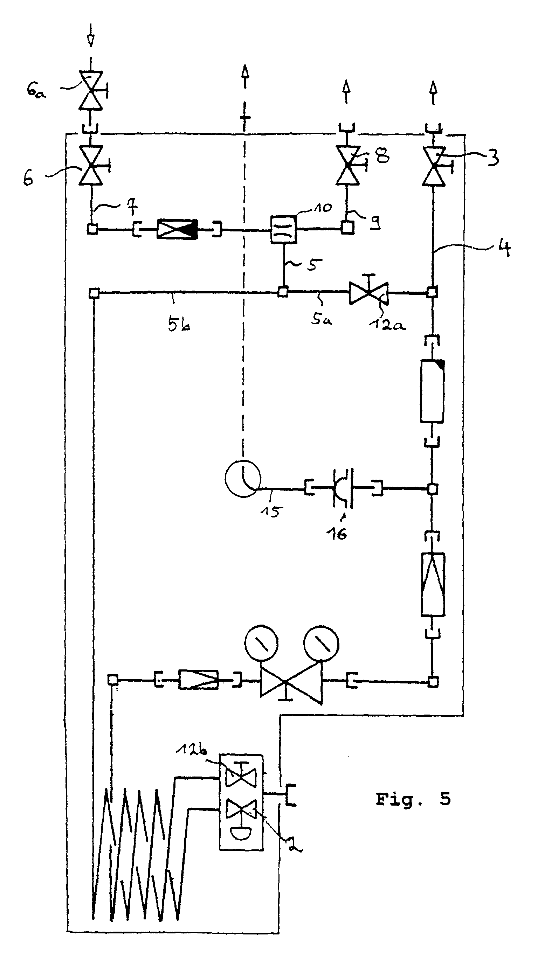

Fig. 5 zeigt die erfindungsgemäße Druckwechselvorrichung in einem Gastableau. Für die Bauteile wurden die selben Bezugszeichen wie in Fig. 2 verwendet, soweit sich die Bauteile identisch entsprechen. In der Prozeßgasleitung 4 sind eine Reihe weiterer Instrumente angeordnet, welche für die Druckwechselspülung von untergeordneter Bedeutung sind. Von der Prozeßgasleitung 4 zweigt eine Notleitung 15 ab, in welcher eine Berstscheibe 16 enthalten ist, die bei zu hohem Druck in der Prozeßgasleitung 4 bricht, und das Prozeßgas kontrolliert ableitet.

An der Spülgaszuleitung 7 kann eine Spülgasflasche mit einem Flaschenventil 6a angeschlossen werden. Der schematische Aufbau des Gastableaus entspricht dem in der Fig. 2 und das Verfahren zur Druckwechselspülung ist ebenso identisch wie in Fig. 2 beschrieben.

Die Spülgasleitung 5b mündet direkt an den Anschluß für die Prozeßgasflasche. Dies hat den Vorteil, daß beim Wechseln der Prozeßgasflasche der Anschluß getrennt gespült werden kann, damit beim Flaschenwechsel kein giftiges Gas ins Freie tritt. Zum Wechseln der Prozeßgasflasche wird das Ventil 2 geschlossen und das Ventil 12b geöffnet. Die Druckwechselspülung erfolgt wie zu Fig. 2 beschrieben, wobei das Spülgas über die Leitungen 7, 5, 5b zugeleitet wird und über die Leitungen 5b und 9 wieder abgezogen wird.

Die Erfindung ist nicht auf das dargestellte Ausführungsbeispiel beschränkt. Ebenso sind Ausführungsformen denkbar, in denen sich die Spülgasleitung 5 nicht aufzweigt.

Ebenso ist es möglich, in einer Vorrichtung, wie sie in Fig. 1 dargestellt ist, anstatt der Vakuumpumpe eine mit Spülgas betriebene Drosseleinrichtung als Vakuumgenerator zu verwenden.

## Patentansprüche

1. Vorrichtung zur Druckwechselspülung eines Raumes (4), insbesondere in einer Prozeßgasanlage, mit
einer mit dem Raum (4) verbundenen Spülgaszuleitung (7), in welcher unter Druck stehendes Spülgas zugeführt wird und
einer ebenso mit dem Raum (4) verbundenen Spülgasableitung (9) und
einer Drosseleinrichtung (10) als Vakuumgenerator, bei welcher der in Strömungsrichtung unmittelbar nach der Drosselung entstehende Unterdruck zur Evakuierung des zu spülenden Raumes genützt wird,
wobei in der Spülgasableitung (9) in Strömungsrichtung des Spülgases nach der Drosseleinrichtung (10) ein Ventil (8) angeordnet ist und die Spülgaszuleitung (7) und die Spülgasableitung (9) miteinander über die Drosseleinrichtung (10) verbunden sind,
**dadurch gekennzeichnet,**
**daß** in Strömungsrichtung der Spülgaszuleitung (7) unmittelbar nach der Drosselung eine gemeinsame Spülgasleitung (5) angordnet ist, die sowohl als Spülgaszu- als auch als Spülgasableitung wirkt und die Spülgaszu-, bzw. Spülgasableitung (7, 9) mit dem zu spülenden Raum verbindet.

2. Vorrichtung nach Anspruch 1, **dadurch gekennzeichnet, daß** die Drosseleinrichtung (10) eine Venturidüse oder eine Meßblende ist.

3. Vorrichtung nach Anspruch 1 oder 2, **dadurch gekennzeichnet, daß** das Ventil (8) über eine Steuereinrichtung betätigbar ist.

4. Vorrichtung nach einem der Ansprüche 1 bis 3, **dadurch gekennzeichnet,** daß"in der Spülgaszuleitung (7) in Strömungsrichtung vor der Drosseleinrichtung ein Ventil (7) angeordnet ist.

5. Vorrichtung nach einem der Ansprüche 2 bis 4, **dadurch gekennzeichnet, daß** sich die Spulgasleitung (5) in mehrere Leitungen (5a, 5b) aufzweigt, welche jeweils mit dem zu spülenden Raum bzw. mit verschiedenen zu spülenden Räumen verbunden sind.

6. Vorrichtung nach einem der Ansprüche 2 bis 5, **dadurch gekennzeichnet, daß** in der Spülgasleitung (5) bzw. in den Zweigleitungen (5a,5b) zumindest ein Ventil (8a,8b) vorgesehen ist.

7. Verfahren zur Druckwechselspülung eines Raumes mit einer Vorrichtung nach einem der vorhergehenden Ansprüche, **dadurch gekennzeichnet, daß** das Ventil (8), welches in Strömungsrichtung des Spülgases nach der Drosseleinrichtung (10) in der Spülgasleitung (9) angeordnet ist, abwechselnd geöffnet und geschlossen wird.

## Claims

1. A device and method for the alternating pressure flushing of a space (4), and especially of a space within a process gas system, including a purge gas supply line (7) connected with the space (4), via which pressurised purge gas can be supplied, and a purge gas drainage pipeline (9) which is also connected with the space (4), and a throttle apparatus (10) serving as a vacuum generator, which can be used to evacuate the under-pressure created in the purged space immediately following the throttling action in the direction of the flow, whereby the purge gas drainage line (9) incorporates a valve (8) inside the throttle apparatus (10) in the direction of the flow of purge gas, and whereby the purge gas supply line (7) and the purge gas drainage line (9) are connected with each other via the throttle apparatus (10), and which is further **characterised by** the fact that a common purge gas line (5) is incorporated immediately following the throttling apparatus in the direction of the gas flow through the purge gas supply line (7), which will function as a purge gas supply line as well as a purge gas drainage line, and whereby either the purge gas supply line or the purge gas drainage line (7, 9) can be connected with the space that is to be purged.

2. A device according to Claim 1, **characterised in that** the throttle apparatus (10) consists of a venturi nozzle or a measuring nozzle.

3. A device according to Claim 1 or 2, **characterised in that** the valve (8) can be activated via a control system.

4. A device according to one of the preceding Claims 1 to 4, **characterised in that** it incorporates a valve (8) in the purge gas supply line (7) in the direction of the flow and prior to the throttle apparatus.

5. A device according to one of the preceding Claims 2 to 4, **characterised in that** the purge gas line (5) is divided into several branches (5a, 5b), which are each connected with the space to be purged, i.e. with various different spaces to be purged.

6. A device according to one of the preceding Claims 2 to 5, **characterised in that** the purge gas line (5), .e. the branch lines (5a, 5b) incorporated at least one valve (8a, 8b).

7. A method for the alternating pressure flushing of a space with the aid of a device according to one of the preceding Claims, **characterised in that** the valve (8) that is incorporated in the purge gas line (9) following the throttle apparatus (10) in the direction of the flow can alternately be opened and closed,

## Revendications

1. Dispositif pour le lavage alterné d'un espace (4), en particulier pour une installation de traitement gazeux,
dans lequel une ligne d'admission d'un gaz de lavage (7) est connectée avec l'espace (4) de sorte que un gaz de lavage y soit injecté sous pression,
dans lequel de même une ligne d'évacuation du gaz de lavage (9) est connectée avec l'espace (4) et
dans lequel un dispositif à étranglement (10) fonctionnant en générateur de vide au moyen duquel une dépression correspondante sera mise en oeuvre immédiatement après l'étranglement dans le sens de circulation pour vider l'espace en cours de lavage,
de sorte que une vanne (8) soit disposée sur la ligne d'évacuation du gaz de lavage (9) dans le sens de circulation du gaz de lavage après le dispositif à étranglement (10) et de sorte que la ligne d'admission de gaz de lavage (7) et la ligne d'évacuation du gaz de lavage soient connectées l'une à l'autre sur le dispositif à étranglement (10),
**caractérisé en ce que**
une ligne de gaz de lavage (5) commune est disposée dans le sens de circulation dans la ligne d'admission de gaz de lavage (7) immédiatement après le dispositif à étranglement (10), la ligne de gaz de lavage (5) commune pouvant être montée non seulement en ligne d'admission, mais aussi en ligne d'évacuation (7, 9) sur l'espace à laver.

2. Dispositif selon la revendication 1, **caractérisé en ce que** le dispositif à étranglement (10) est constitué par un ajutage de Venturi ou par un diaphragme contrôlé en diamètre.

3. Dispositif selon la revendication 1 ou 2, **caractérisé en ce que** la vanne (8) est commandée au moyen d'un dispositif de pilotage.

4. Dispositif selon l'une des revendications 1 à 3, **caractérisé en ce que** une vanne (6) est disposée sur la ligne d'admission de gaz de lavage (7) avant le dispositif à étranglement (10) dans le sens de circulation du flux gazeux.

5. Dispositif selon l'une des revendications 2 à 4, **caractérisé en ce que** la ligne de gaz de lavage (5) est ramifiée en une pluralité de lignes (5a, 5b) lesquelles sont respectivement connectées à l'espace (4) à laver ou bien aux divers espaces (4) à laver.

6. Dispositif selon l'une des revendications 2 à 5, **caractérisé en ce que** au moins une vanne (12a, 12b) est prévue sur la ligne de gaz de lavage (5) ou bien sur les lignes ramifiées (5a, 5b).

7. Procédé de lavage alterné sous pression d'un espace au moyen d'un dispositif selon l'une des revendications précédentes, **caractérisé en ce que** la vanne (8), qui est disposée après le dispositif à étranglement (10) dans le sens de circulation du gaz de lavage sur la ligne de gaz de lavage (9), est alternativement ouverte et fermée.
